**Europäisches Patentamt**

**European Patent Office**

**Office européen des brevets**

(19)

(11) **EP 1 398 834 A2**

(12) **EUROPÄISCHE PATENTANMELDUNG**

(43) Veröffentlichungstag:
**17.03.2004 Patentblatt 2004/12**

(51) Int Cl.⁷: **H01L 23/522**, H01L 23/528

(21) Anmeldenummer: **03017978.2**

(22) Anmeldetag: **06.08.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **12.09.2002 DE 10242324**

(71) Anmelder: **Infineon Technologies AG**
**81609 Munich (DE)**

(72) Erfinder:
• **Steinecke, Thomas**
**85457 Wörth (DE)**
• **Lohmair, Franz**
**83620 Feldkirchen-Westerham (DE)**

(74) Vertreter: **Patentanwälte**
**Westphal, Mussgnug & Partner**
**Mozartstrasse 8**
**80336 München (DE)**

(54) **Elektronisches Bauteil mit Spannungsversorgungsstruktur und Verfahren zu dessen Herstellung**

(57) Die Erfindung betrifft ein elektronisches Bauteil und einen Halbleiterwafer sowie ein Verfahren zur Herstellung desselben. Das elektronische Bauteil umfasst mindestens einen Halbleiterchip, der aus entsprechenden Chippositionen eines erfindungsgemäßen Halbleiterwafers gewonnen ist. Dabei weist der Halbleiterchip zwei oberste Metallisierungslagen (5, 6) auf, die flächendeckende Spannungsversorgungsstrukturen (9) mit dazwischen angeordneten Isolationslagen und Durchgangskontakten (17) zu Modulbereichen einer integrierten Schaltung aufweisen. Die Spannungsversorgungsstruktur (9) weist ein Gitter (19) von parallel zueinander angeordneten Versorgungsleiterbahnen (20) auf, das gegenüber einem Gitter (21) einer nachfolgenden Metallisierungslage verdreht ist.

FIG 7

EP 1 398 834 A2

**Beschreibung**

Die Erfindung betrifft ein elektronisches Bauteil und einen Halbleiterwafer mit Halbleiterchips, die auf ihren aktiven Oberseiten im Wechsel übereinander angeordnete Metallisierungslagen und Isolationslagen gemäß dem Oberbegriff der unabhängigen Ansprüche aufweisen. Darüber hinaus betrifft die Erfindung ein Verfahren zur Herstellung derselben.

Aus der Druckschrift US 5,939,766 ist ein Kondensator für integrierte Schaltungen im Bereich von Metallisierungslagen eines Halbleiterchips bekannt. Der Kondensator weist eine kammförmige Leiterbahnstruktur auf, wobei parallel angeordnete Leiterbahnen zweier Kammstrukturen ineinander greifen. Dabei wird die Kapazität des Kondensators durch den Abstand zwischen den ineinander greifenden parallel angeordneten Leiterbahnen innerhalb einer Metallisierungslage bestimmt. Darüber hinaus ist aus der Druckschrift ein Kondensator bekannt, der eine weitere gleichartige Kammstruktur aufweist, die jedoch in einer darunter angeordneten Metallisierungslage angeordnet ist. Die gesamte Kapazität des Kondensators wird einerseits durch die Abstände der ineinander greifenden Kammstrukturen jeder Metallisierungslage und zusätzlich durch den Abstand zwischen den Metallisierungslagen bestimmt. Dazu sind die parallelen Leiterbahnstrukturen in den beiden Metallisierungslagen in gleicher Richtung ausgerichtet. Somit wird erreicht, dass ein derartiger Kondensator nur einen Bruchteil der Oberfläche eines Halbleiterchips für eine ausreichende Kapazität des Kondensators benötigt. Die verbleibende Fläche der Metallisierungsschicht kann für Signalleiterbahnen und Versorgungsleiterbahnen eingesetzt werden.

Ein Nachteil eines derartigen Halbleiterchips ist ein hoher Flächenbedarf aufgrund der Anordnung von Konsensatorleiterbahnen, Versorgungsleiterbahnen und Signalleiterbahnen in jeder der Metallisierungsebenen, so dass eine automatische Verdrahtung mit "Place+Route"-Programmen erschwert bzw. in vielen Fällen unmöglich ist. Mit automatischen "Place+Route"-Programmen, im Folgenden PR-Programme genannt, können Funktionseinheiten integrierter Schaltungen, wie NOR-Gates, AND-Gates, NAND-Gates, Operationsverstärker, Impedanzmodule, TTL-Bausteine und andere beliebig aneinander gesetzt und automatisch miteinander verdrahtet werden. Dieses setzt jedoch eine gleichbleibende Metallisierungslagendicke pro Metallisierungslage voraus, was insbesondere bei der Dimensionierung von Versorgungsleitungen auf gleicher Ebene mit Signalleitungen und auf gleicher Ebene mit der aus der US-Druckschrift bekannten Kondensatorstruktur einen hohen Flächenbedarf verursacht.

Aufgabe der Erfindung ist es, ein elektronisches Bauteil mit einem Halbleiterchip sowie einen Halbleiterwafer zu schaffen, bei dem die Schichtfolge der Metallisierungslagen in Bezug auf den Gesamtflächenbedarf optimiert ist und eine automatische Verdrahtung mit Hilfe von PR-Programmen erfolgen kann.

Diese Aufgabe wird mit dem Gegenstand der unabhängigen Ansprüche gelöst. Vorteilhafte Weiterbildungen ergeben sich aus den abhängigen Ansprüchen.

Erfindungsgemäß wird ein elektronisches Bauteil mit einem Halbleiterchip geschaffen, der auf seiner aktiven Oberseite im Wechsel übereinander angeordnete Metallisierungslagen und Isolationslagen aufweist. Dabei weisen die Metallisierungslagen Spannungsversorgungsstrukturen und/oder Signalleitungsstrukturen auf. In den Isolationslagen sind Durchgangskontakte angeordnet, welche die Spannungsversorgungsstrukturen und die Signalleitungsstrukturen mit Kontaktflächen der aktiven Oberseite des Halbleiterchips verbinden. Die obersten Metallisierungslagen weisen flächendeckende Spannungsversorgungsstrukturen und dazwischen angeordnete Isolationslagen mit Durchkontakten zu Modulbereichen der integrierten Schaltung auf. Dabei sind mindestens zwei voneinander isolierte Spannungsversorgungsstrukturen für ein niedriges und für ein hohes Versorgungspotential vorgesehen. Die Spannungsversorgungsstrukturen der oberen Metallisierungslagen weisen jeweils Gitter von parallel zueinander angeordneten Versorgungsleiterbahnen auf, wobei aufeinander folgende Gitter von aufeinander folgenden Metallisierungslagen gegeneinander verdreht sind. Unterhalb der Metallisierungslagen für eine Spannungsversorgung sind Metallisierungslagen für Signalleitungsstrukturen angeordnet.

Ein derartiges elektronisches Bauteil mit einem derartigen Halbleiterchip hat den Vorteil, dass durch die lagenweise Trennung von flächendeckenden Spannungsversorgungsstrukturen auf oberen Metallisierungslagen und darunter angeordneten Metallisierungslagen mit Signalleitungsstrukturen die Metallisierungsdicke den jeweiligen Aufgaben der Strukturen angepasst werden kann. So können in den obersten Metallisierungslagen wesentlich dickere Metallstrukturen vorgesehen werden, um den Flächenbedarf für die Spannungsversorgungsstrukturen zu vermindern. In den darunter angeordneten Metallisierungslagen können die Metalldicken äußerst gering und den schwachen Signalströmen angepasst sein.

Ein weiterer Vorteil ist, dass nun flächendeckend eine Spannungsversorgung für die gesamte Fläche des Halbleiterchips zur Verfügung steht, so dass eine automatisch generierbare EMV optimierte Verdrahtung mittels PR-Programmen möglich wird. Die Funktionsmodule der unteren Metallisierungslagen können mit Spannung versorgt werden, ohne dass eine Verdrahtung mit zusätzlichem Flächenbedarf zwischen den Signalleitungsstrukturen der Funktionsmodule vorzusehen sind. Die Funktionsmodule werden vielmehr von "oben" wie von Stromversorgungsschienen oder wie von Fahrdrähten versorgt. Schließlich kann durch die frei wählbare Dicke der Metallisierung der oberen Metallisierungslagen eine niederimpedante Versorgung der Funktionsmodule der integrierten Schaltung gewährleistet werden, womit auch die Gefahr von Spannungseinbrüchen in der Spannungsversorgungsstruktur minimiert wird.

Ein weiterer Vorteil eines derartigen elektronischen Bauteils mit einem Halbleiterchip, der auf seinen obersten Metallisierungslagen Spannungsversorgungsstrukturen aufweist, liegt darin, dass ein Ladungspuffer durch die parallel zueinander angeordneten gitterförmigen Versorgungsleiterbahnen über kapazitive Kopplung geschaffen wird, womit eine schnelle und lokale Bereitstellung von Schaltströmen für die darunter liegenden Funktionsmodule und für die integrierten Schaltungsstrukturen des Halbleiterchips geschaffen werden.

In einer bevorzugten Ausführungsform der Erfindung weist der Halbleiterchip eine in Funktionsmodulbereiche gegliederte integrierte Schaltung auf. Dazu ist jeder Modulbereich über entsprechende Elektroden oder Anschlussleitungen und über Durchkontakte mit den Spannungsversorgungsstrukturen der oberen Metallisierungslagen verbunden. Somit können die Funktionsmodulbereiche eng benachbart zueinander auf dem Halbleiterchip angeordnet werden, zumal keine zusätzlichen Flächen zum Heranführen von Versorgungsspannungen über entsprechende Spannungsversorgungsstrukturen an die einzelnen Modulbereiche der integrierten Schaltung zwischen den Funktionsmodulen erforderlich sind, sondern vielmehr die gesamte Spannungsversorgung über die flächendeckende Spannungsversorgungsstruktur der oberen Metallisierungslagen und über Durchkontakte zu den Elektroden bzw. Anschlussleitungen der Modulbereiche erfolgt.

Als Halbleiterchip für das elektronische Bauteil ist ein Siliciumchip aus monokristallinem Material vorgesehen, der in Bereichen seiner aktiven Oberseite eine integrierte Schaltung aufweist, deren Kontaktflächen mit den darüber angeordneten Leiterbahnen über Durchkontakte durch die Isolationslagen elektrisch verbunden ist, wobei die elektrischen Verbindungen automatisch mittels PR-Programmen verdrahtbar sind. Eine derartige automatische Verdrahtbarkeit der Spannungsversorgungsstrukturen der oberen Metallisierungslagen hat den Vorteil einer beliebigen Erweiterbarkeit der Funktionen der integrierten Schaltung durch Angliedern und automatische Verdrahtung von weiteren Modulbereichen, ohne dass zusätzliche grundlegende manuelle Entwicklungsmaßnahmen erforderlich werden.

In einer weiteren Ausführungsform der Erfindung weisen die parallel zueinander innerhalb einer Metallisierungslage angeordneten Versorgungsleiterbahnen alternierend unterschiedliche elektrische Versorgungspotentiale auf. Mit dieser Maßnahme wird erreicht, dass die Seitenflächen der parallel zueinander angeordneten Versorgungsleiterbahnen durch ihre kapazitive Kopplung als Ladungspuffer für die Funktionsmodule der integrierten Schaltung dienen, was eine schnelle lokale Bereitstellung von Schaltströmen verbessert. Dabei wirkt sich die mögliche dickere Ausführung der Metallisierung der oberen Metallisierungslagen gegenüber den unteren Metallisierungslagen für die Signalleitung kapazitätserhöhend aus. Je dicker die Metallisierung der Spannungsversorgungsstrukturen ausfällt, umso größer ist die Möglichkeit der kapazitiven Kopplung von parallel angeordneten Versorgungsleiterbahnen auf unterschiedlichen elektrischen Versorgungspotentialen. Neben der Dicke der Metallisierung können auch die Abstände der innerhalb einer Metallisierungslage parallel zueinander angeordneten Versorgungsleiterbahnen mit alternierenden Versorgungsspannungen zur Erhöhung der kapazitiven Kopplung beitragen, indem sie derart dimensioniert sind, dass sie eine höchstmögliche elektrische Kapazität mit ausreichender Spannungfestigkeit aufweisen.

Bei einer weiteren Ausführungsform der Erfindung liegen die parallel zueinander angeordneten Versorgungsleiterbahnen innerhalb einer oberen Metallisierungslage auf gleichem elektrischen Versorgungspotential, womit innerhalb ein und derselben Metallisierungslage kein Ladungspuffer geschaffen wird, jedoch liegen die dazu verdrehten Gitter der nachfolgenden Metallisierungslagen auf einem unterschiedlichen Versorgungspotential. so dass die einander gegenüberliegenden Kreuzungsflächen einen Ladungspuffer durch ihre kapazitiven Kopplungsflächen bilden und damit eine schnelle lokale Bereitstellung von Schaltströmen ermöglichen. Dazu kann in vorteilhafter Weise die Dicke der Isolationslagen zwischen den obersten Metallisierungslagen derart dimensioniert sein, dass die übereinander angeordneten Kreuzungsflächen der Gitter zweier Spannungsversorgungsstrukturen eine höchstmöglich elektrische Kapazität mit ausreichender Spannungsfestigkeit bilden.

Die Metallisierungslagen können polykristallines Silicium, Kupfer, Aluminium, Nickel oder Legierungen des Kupfers des Aluminiums oder des Nickels aufweisen. Das polykristalline Silicium wird als Metallisierungslagenmaterial hoch dotiert, so dass seine Ladungsträgerkonzentration über $10^{21}$ cm$^{-3}$ beträgt, was bereits an die Ladungsträgerkonzentration von Metallen heranreicht. Dabei wird polykristallines Silicium als Metallisierungslage vorzugsweise in den unteren Metallisierungslagen für die Signalleitung eingesetzt und hat sich insbesondere als Gate-Elektrodenmaterial bewährt.

Kupfer und seine Legierungen werden zunehmend für Signalleiterbahnen eingesetzt, zumal die Migrationsgefahr von Kupfer und Kupferlegierungen gegenüber Aluminium minimiert ist und Leiterbahnen aus Kupfer oder Kupferlegierungen mit einer Breite im Submikrometerbereich darstellbar sind. Nickel und Nickellegierungen werden häufig als Diffusionsstoppschichten sowohl für Spannungsversorgungsstrukturen als auch für Signalleitungsstrukturen gegenüber Kupferleiterbahnen eingesetzt. Aluminium und seine Legierungen bilden vorzugsweise dicke Spannungsversorgungsleiterbahnen mit hoher kapazitiver Kopplung aus.

Als Isolationslagenmaterial werden in vorteilhafter Weise Siliciumdioxid und/oder Siliciumnitrid eingesetzt, die aufgrund ihrer hohen Spannungsfestigkeit in äußerst dünnen Schichten teilweise unter einem µm bereits eine ausreichende Spannungsfestigkeit zwischen Metallagen zur Versorgung integrierter Schaltungen aufweisen. Daneben lassen sich als Isolationslagenmaterial auch Polymerkunststoffe wie Polyimid einsetzen, die jedoch aufgrund ihrer geringeren Spannungsfestigkeit dicker als die keramischen Schichten aus Siliciumdioxid und Siliciumnitrid vorgesehen werden.

Die vorliegende Erfindung bezieht sich weiterhin auf einen Halbleiterwafer mit mehreren Halbleiterchippositionen, die in Zeilen und Spalten auf einer aktiven Oberseite des Halbleiterwafers angeordnet sind. Dazu weist der Halbleiterwafer im Wechsel übereinander angeordnete strukturierte Metallisierungslagen und Isolationslagen mit Durchkontakten in jeder Chipposition auf. Über die Durchgangskontakte der Isolationslagen sind die Kontaktflächen auf der aktiven Oberseite des Halbleiterwafers mit den Spannungsversorgungsstrukturen und/oder den Signalleitungsstrukturen verbunden. Die oberen Metallisierungslagen des Halbleiterwafers bilden flächendeckende Spannungsversorgungsstrukturen mit dazwischen angeordneten Isolationslagen in jeder der Halbleiterchippositionen. Dazu weisen voneinander isolierte Spannungsversorgungsstrukturen mindestens ein niedriges und ein hohes Versorgungspotential auf und bilden ein Gitter von parallel zueinander angeordneten Versorgungsleiterbahnen aus, wobei aufeinanderfolgende Gitter in einem Stapel von Metallisierungslagen zueinander verdreht sind. Die unteren Metallisierungslagen weisen jeweils Signalleitungsstrukturen auf.

Die zueinander verdrehten Gitter der Spannungsversorgungsleiterbahnen bilden für übereinander angeordnete Metallisierungslagen vorzugsweise einen Verdrehwinkel von 90° aus. Damit bilden sich zwischen den Spannungsversorgungsstrukturen gegenüberliegende Kreuzungsflächen aus, die einen Ladungspuffer aufgrund ihrer Koppelkapazität darstellen. Die Verdrahtung der Spannungsversorgungsstrukturen kann automatisch mit Hilfe von PR-Programmen vorgenommen werden, zumal innerhalb einer Metallisierungslage eindeutig entweder nur Spannungsversorgungsleiterbahnen oder nur Signalleiterbahnen auftreten, zumal diese jeweils flächendeckend vorgesehen sind.

Nur in Ausnahmefällen können auch Signalleiterbahnen zusätzlich in die oberen Metallisierungslagen eingebaut werden, insbesondere dann, wenn kurze Verbindungen zu den Elektroden der integrierten Schaltung in dem Halbleiterchip zu realisieren sind, und Signalleitungsführungen über die unteren Metallisierungslagen sich zu einer zu großen Länge summieren.

Jede Halbleiterposition des Halbleiterwafers weist eine in Funktionsmodulbereiche gegliederte integrierte Schaltung auf, wobei jeder Modulbereich über seine Elektroden oder Anschlußleitungen und über die Durchgangskontakte mit den Spannungsversorgungsstrukturen der oberen Metallisierungslagen verbunden ist. Die Vorteile einer derartigen Anordnung sind die gleichen, wie sie bereits für den Halbleiterchip präzisiert wurden. Auch die weiteren vorteilhaften Ausführungsformen des elektronischen Bauteils mit einem Halbleiterchip sind auf die Halbleiterchippositionen eines Halbleiterwafers übertragbar und die Erörterung der damit verbundenen Vorteile wird zur Vermeidung von Wiederholungen an dieser Stelle weggelassen.

Ein Verfahren zur Herstellung eines Halbleiterwafers mit mehreren Halbleiterchippositionen und mit mindestens zwei oberen Metallisierungslagen als Spannungsversorgungsstrukturen mit parallelen Versorgungsleiterbahnen in jeder der Halbleiterchippositionen, wobei die parallelen Versorgungsleitungen der oberen Metallisierungslagen quer zu den parallelen Versorgungsleitungen der darunter angeordneten Metallisierungslagen ausgerichtet sind, weist folgende Verfahrensschritte auf:

- Herstellen eines Halbleiterwafers mit mehreren Halbleiterchippositionen, die Signalleitungsstrukturen aufweisende Metallisierungslagen und dazwischen angeordnete Isolationslagen mit Durchgangskontakten aufweisen, wobei die Signalleitungsstrukturen über die Durchgangskontakte mit Kontaktflächen auf der aktiven Oberseite des Halbleiterwafers verbunden sind,

- Aufbringen einer geschlossenen Metallisierungslage auf eine oberste Isolationslage der Signalleitungsstrukturen,

- Strukturieren der geschlossenen Metallisierungslage zu einem Gitter aus parallelen Versorgungsleiterbahnen als erste Spannungsversorgungsstruktur, wobei die Lage der Versorgungsleiterbahnen mittels "Place-Route"-Programmen automatisch entworfen werden,

- Aufbringen einer Isolationslage auf die Spannungsversorgungsstruktur mit Durchgangskontakten zu Kontaktflächen auf der aktiven Oberseite, wobei die Positionierung der Durchgangskontakte mit einer Photolithographiemaske erfolgt, die mittels "Place-Route"-Programmen automatisch entworfen wird,

- Aufbringen und Strukturieren einer weiteren Metallisierungslage mit einem Gitter aus parallelen Versorgungsleiterbahnen, die gegenüber der Richtung der ersten Spannungsversorgungsstruktur verdreht angeordnet sind und deren Lage mittels "Place-Route"-Programmen automatisch entworfen werden,

- Aufbringen einer Passivierungsschicht unter Freilassen von Kontaktanschlussflächen, die mit Durchgangskontakten elektrische in Verbindung stehen.

Dieses Verfahren hat den Vorteil, dass es einen Halbleiterwafer, insbesondere einen Halbleiterwafer aus einem Silicium-Einkristall mit Metallisierungsstrukturen versieht, die als oberste Metallisierungstruktur Spannungsversorgungsstrukturen aufweist, welche mittels PR-Programmen automatisch entworfen werden. Durch die Flächeneinsparung, weil nun Spannungsversorgungsleiterbahnen nicht mehr neben Signalleiterbahnen in gleichen Metallisierungslagen verlaufen, sondern sämtliche Spannungsversorgungsstrukturen in getrennten oberen Metallisierungslagen realisiert werden, kann auf gleich großen Wafern von beispielsweise 300 cm Durchmesser eine höhere Anzahl an Halbleiterchippositionen vorgesehen werden. Darüber hinaus wird gleichzeitig eine größere Pakkungsdichte von elektronischen Schaltfunktionen in dem Halbleiterwafer erreicht.

Ein Verfahren zur Herstellung eines elektronischen Bauteils unter Auftrennen des hergestellten Halbleiterwafers in Halbleiterchips kann weitere folgende Verfahrensschritte aufweisen:

- Aufbringen der Halbleiterchips auf einen Schaltungsträger mit mehreren Bauteilpositionen,
- Herstellen von Bondverbindungen zwischen dem Schaltungsträger und den Kontaktanschlußflächen der Halbleiterchips in jeder Bauteilposition,
- Verpacken der Halbleiterchips mit Bondverbindungen in einem Kunststoffgehäuse mit Außenkontakten in jeder Bauteilposition,
- Auftrennen des Schaltungsträgers in mehrere elektronische Bauteile.

Mit diesem Verfahren ist der Vorteil verbunden, dass für mehrere Halbleiterchips auf einem Schaltungsträger gleichzeitig Bondverbindungen nach vorgegebenen Plänen durchgeführt werden können, und auch gleichzeitig ein Verpacken von mehreren elektronischen Bauteilen auf ein und demselben Schaltungsträger möglich werden. Nach einem Trennen des Schaltungsträgers in einzelne elektronische Bauteile entstehen dann Bauteile mit völlig identischem Gehäuse.

Zusammenfassend ist festzustellen, dass künftige hochintegrierte digitale Schaltungen, die in Mehrlagen-Metallisierungsprozessen gefertigt werden, eine große Anzahl verfügbarer Metalllagen aufweisen, die es ermöglichen, erfindungsgemäß zwischen Signalverdrahtungen und Spannungsversorgungsverdrahtungen zu unterscheiden und die oberen Metalllagen für Spannungsversorgungsstrukturen vorzusehen und die darunter liegenden Metalllagen ausschließlich für die Signalleitungsstrukturen zu reservieren.

Dazu können die obersten Metallagen der Spannungsversorgung der einzelnen Funktionsmodule der integrierten Schaltung eines Halbleiterchips dienen. Die Module der integrierten Schaltung, die unterhalb der Versorgungslagen liegen, greifen somit ihre Versorgungsspannung wie "Lokomotiven" von einem "Fahrdraht" ab. Der große Vorteil einer solchen "Fahrdrahtrealisierung" der Modulversorgung ist deren Flächenneutralität. Während gegenwärtig mangels verfügbarer Metalllagen die Modulversorgung in Kanälen zwischen den Modulen angeordnet wird und somit zusätzliche Chipfläche benötigt wird, kann mit Hilfe der vorliegenden Erfindung die Modulversorgung bei Verfügbarkeit ausreichender Metalllagen oberhalb der Module angeordnet werden, wobei die Module selbst direkt und ohne Zwischenkanäle aneinander stoßen. Somit lässt sich ein elektronisches Bauteil realisieren, das bei gleicher Funktionalität eine geringere Chipfläche erfordert oder bei gleicher Chipfläche nun eine höhere Funktionalität und damit auch eine höhere Schaltungsdichte aufweist. Sollte der Strombedarf der Module weiter wachsen, können beliebig viele Spannungsversorgungsstrukturen übereinander in voneinander isolierten Metallisierungslagen untergebracht werden.

Werden lediglich zwei Versorgungspotentiale angeboten, so kann mit minimal zwei Metalllagen ein Versorgungskonzept vollständig realisiert werden, wobei die obersten beiden Metalllagen für die Spannungsversorgung eingesetzt werden, und die Versorgung nicht über die Modulverdrahtung erfolgt, so dass die Spannungsversorgungsleitungen nicht innerhalb der Signalverdrahtung für die Funktionsmodule verlaufen. Die Funktionsmodule befinden sich somit vollständig unterhalb der Spannungsversorgungslagen.

Automatische Verdrahtungswerkzeuge wie PR-Programme haben Vorzugsrichtungen für die Führung der Signal- und Versorgungsleitungen. Dazu werden die Metallbahnen der Spannungsversorgungsstrukturen in je zwei übereinander liegenden Metallisierungsebenen vorzugsweise orthogonal zueinander geführt. Die Kreuzung von Metallbahnen ist folglich nur in darüber oder darunter liegenden Ebenen möglich. Die erfindungsgemäße Versorgungsstruktur trägt dieser Anforderung von automatischen PR-Programmen Rechnung und weist in den verfügbaren mindestens zwei Metallisierungsebenen für die Spannungsversorgung jeweils vorzugsweise orthogonal zueinander verdrehte Versorgungsbahnen auf.

Mit Hilfe der Erfindung wird eine niederimpedante Versorgung der Funktionsmodule unter Minimierung der Spannungseinbrüche erreicht. Aufgrund der Forderung nach automatischer Verdrahtung können nicht sog. Versorgungsflächen zur Verfügung gestellt werden, die jeweils eine vollständig geschlossene Metallisierungslage für eines der Potentiale zur Verfügung stellen, wobei Durchbrüche in der unten liegenden Versorgungslage vorzusehen wären, um die Versorgungsspannung der oberen Lage durch die Platte für das zweite Versorgungspotential isoliert hindurchzuführen. Eine derartige plattenförmige Bereitstellung von Spannungsversorgungsstrukturen ist mit hohem manuellem Aufwand verbunden, da PR-Programme dafür nicht vorgesehen sind.

Mit der erfindungsgemäßen Strukturierung von parallel zueinander verlaufenden gitterförmig angeordneten Spannungsversorgungsleitungen, die in aufeinanderfolgenden Metallisierungslagen gegeneinander verdreht sind, können die Randbedingungen für ein automatisches Entwerfen von Verdrahtungsführungen mittels PR-Programmen erfüllt werden. Durch die Verfügbarkeit von sehr vielen parallel verlaufenden Leitungen kann auch die Forderung nach einer hohen Strombelastbarkeit der Spannungsversorgungsstrukturen erfüllt werden.

Gleichzeitig wird in der vorliegenden Erfindung neben einer hohen Strombelastbarkeit auch ein Ladungspuffer durch kapazitive Kopplung zur Verfügung gestellt. Die Ladungspuffer bedeuten einen Vorteil in Bezug auf den für schnelle Schaltvorgänge lieferbaren Strom. Insbesondere hochfrequente Anteile des Ladungsstroms können dann vor Ort von diesen Puffermitteln bereitgestellt werden. Auf diese Weise wird die Übertragung des hochfrequenten Schaltströmen und deren harmonischer elektromagnetischen Schwingungen in Gebiete außerhalb des Halbleiterchips vermieden. Damit bietet der erfindungsgemäße Halbleiterchip einen Vorteil für die elektromagnetische Verträglichkeit, zumal hochfrequente Schaltströme nicht auf Strukturen übertragen werden, wie beispielsweise Strukturen einer angrenzenden Leiterplatte, und somit dort auch keine Störungen verursachen.

In modernen IC-Fertigungsprozessen ist die vertikale Koppelkapazität teilweise kleiner als die laterale Koppelkapazität zwischen parallel verlaufenden Leiterbahnen, zumal die Breite der Metallbahnen im Vergleich zu deren Höhe ständig reduziert wird. Während bei der Signalverdrahtung ein Parallelverlaufen von Leiterbahnen wegen der Gefahr des Übersprechens vermieden wird, liefert das parallele Verlaufen von Spannungsversorgungsleiterbahnen eine hohe kapazitive Kopplung, die aufgrund der Bereitstellung eines Ladungspuffers für schnell verlaufende Schaltungsvorgänge vorteilhaft ist. Somit führt eine abwechselnde Anordnung von parallelen Spannungsversorgungsleitungen mit positivem und negativem Potential in einer Metallisierungslage zu einer vorteilhaften hohen kapazitiven Kopplung der beiden Spannungspotentiale.

Die Erfindung wird nun anhand von Ausführungsformen mit Bezug auf die Figuren 1 bis 8 näher erläutert.

Figur 1    zeigt eine schematische Draufsicht auf einen Halbleiterchip eines elektronischen Bauteils einer ersten Ausführungsform der Erfindung,

Figur 2    zeigt einen schematischen Querschnitt eines Lagenplans eines Halbleiterchips mit mehreren Metallisierungslagen einer zweiten Ausführungsform der Erfindung,

Figur 3    zeigt einen schematischen Querschnitt eines Lagenplans des Halbleiterchips der Figur 2 im Winkel von 90° zu einem Lagenquerschnitt der Figur 2,

Figur 4    zeigt eine schematische perspektivische Ansicht eines Ausschnittes oberer Metallisierungslagen mit Durchgangskontakten einer dritten Ausführungsform der Erfindung,

Figur 5    zeigt eine schematische perspektivische Ansicht eines Ausschnitts oberer Metallisierungslagen mit Durchgangskontakten der Ausführungsform der Figur 4,

Figur 6    zeigt eine schematische perspektivische Ansicht eines Ausschnitts oberer Metallisierungslagen mit Durchgangskontakten einer vierten Ausführungsform der Erfindung,

Figur 7    zeigt eine schematische perspektivische Ansicht eines Ausschnitts oberer Metallisierungslagen mit Durchgangskontakten einer fünften Ausführungsform der Erfindung,

Figur 8    zeigt eine schematische perspektivische Ansicht eines Halbleiterwafers mit mehreren Halbleiterchippositionen für elektronische Bauteile gemäß der Erfindung.

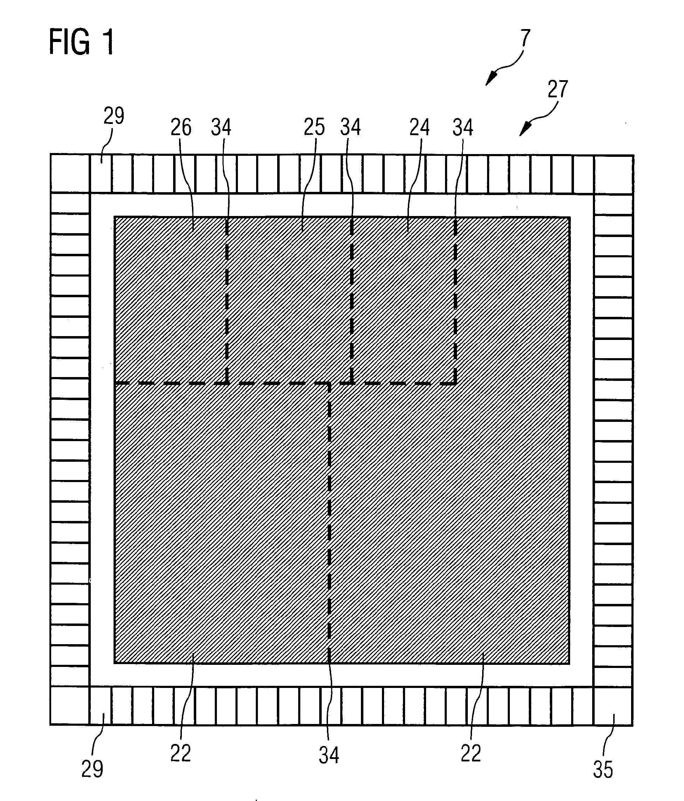

Figur 1 zeigt eine schematische Draufsicht auf einen Halbleiterchip 7 eines elektronischen Bauteils einer ersten Ausführungsform der Erfindung. Die Oberseite des Halbleiterchips zeigt fünf Modulbereiche 22-26, die unmittelbar aneinandergrenzen, ohne dass zwischen den Modulbereichen 22-26 Spannungsversorgungsleitungen vorgesehen sind. Die Grenzen der Modulbereiche 22-26 werden durch die gestrichelten Linien 34 markiert. Die Spannungsversorgung des Halbleiterchips 7 erfolgt über obere, hier nicht markierte Metallisierungslagen, die parallel zueinander angeordnete Spannungsversorgungsleitungen aufweisen und sich flächendeckend über die gesamte, in Figur 1 schwarz markierte Fläche erstrecken. Der Randbereich 35 des Halbleiterchips 7 ist für Kontaktanschlussflächen 29 vorgesehen, die über hier nicht sichtbare Durchgangskontakte und über hier nicht sichtbare Leiterbahnen über die Metallisierungslagen mit den Elektroden der integrierten Schaltung 27 verbunden sind.

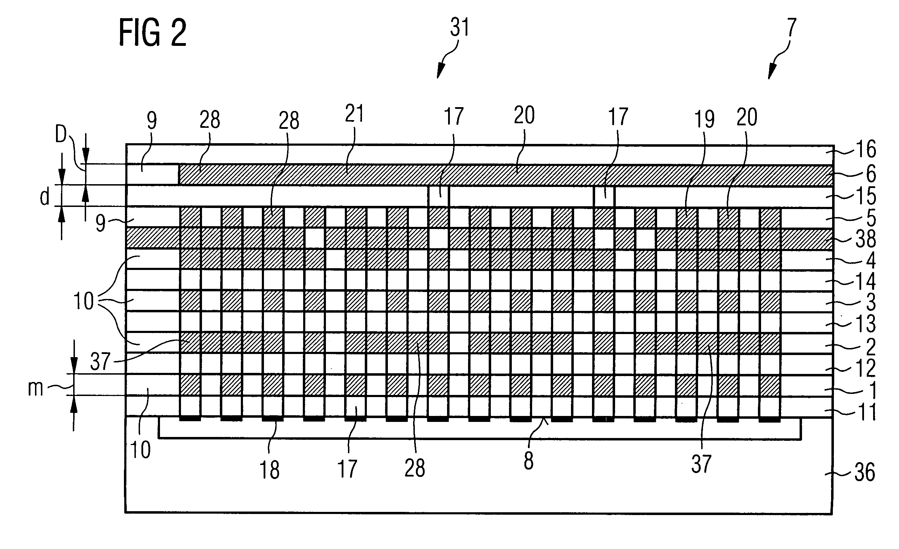

Figur 2 zeigt einen schematischen Querschnitt eines Lagenplans eines Halbleiterchips 7 mit mehreren Metallisierungslagen 1-6 einer zweiten Ausführungsform der Erfindung. Mehrere Metallisierungslagen 1-6 sind auf einem Halbleitersubstrat 36 angeordnet. Vor einem Auftrennen des Halbleitersubstrats 36 in mehrere Halbleiterchips 7 kann dieses aus einem einkristallinen Siliciumwafer bestehen, der auf seiner aktiven Oberseite 8 mehrere Halbleiterchippositionen 31 aufweist. In jeder der Halbleiterchippositionen 31 sind im Bereich der aktiven Oberseite 8 Kontaktflächen 18 angeordnet, welche die Elektroden der einzelnen Halbleiterbauelemente der integrierten Schaltung bilden. Diese Elektroden sind zu Funktionsmodulbereichen der integrierten Schaltung, wie sie in Figur 1 zu sehen sind, zusammengeschaltet, wobei die ersten vier Metallisierungslagen 1-4 Signalleitungen aufweisen, die über Durchgangskontakte 17 untereinander und zu den Kontaktflächen 18 des Halbleitersubstrats 36 verbunden sind.

Die Dicke m der Signalleiterbahnen der Metallisierungslagen 1-4 ist in diesem Ausführungsbeispiel wesentlich geringer als die Dicke D der oberen Metallisierungslagen mit parallel verlaufenden Versorgungsleiterbahnen 20. Von der obersten Versorgungsleiterbahn 20 ist in dem schematischen Querschnitt der Figur 2 nur eine langgestreckte Versorgungsleiterbahn 20 der parallel und gitterförmig angeordneten Versorgungsleiterbahnen quergeschnitten, während von der darunter angeordneten Metallisierungslage 5 sämtliche parallel verlaufende Versorgungsleiterbahnen 20 im Querschnitt zu sehen sind. Da es sich lediglich um einen Lagenplan handelt, ist der Querschnitt jeder Versorgungsleiterbahn 20 nur symbolisch angedeutet und entspricht nicht der wahren Größe. Das Gleiche gilt insbesondere für die Dicke d der zwischen den Metallisierungslagen angeordneten Isolationslage mit Durchgangskontakten 17.

Während die Dicke m der unteren Metallisierungslagen 1-4 für die Signalverdrahtung beispielsweise im Bereich zwischen 0,3 und 2 µm liegt, weisen die Versorgungsleiterbahnen 20 beispielsweise eine Dicke D zwischen 2 µm und 15 µm in dieser Ausführungsform der Erfindung auf. Zwischen den Metallisierungslagen 1-6 sind Isolationslagen 11-15 angeordnet, die Durchgangskontakte 17 aufweisen, um die Leiterbahnen 28 für jeden in Figur 1 gezeigten Modulbereich 22 - 26 untereinander zu verbinden. Zwischen den beiden oberen Metallisierungslagen 5 und 6 für eine Spannungsversorgung und den darunter angeordneten Metallisierungslagen 1-4 für die Signalleitung innerhalb der einzelnen Modulbereiche ist eine Fahrdrahtlage 38 angeordnet, die langgestreckte Durchgangskontakte wie ein "Fahrdraht für eine Lokomotive" die Versorgungsspannung der oberen Metallisierungslagen 5 und 4 auf die darunter liegenden Modulbereiche mit ihren Signalleitungsstrukturen 10 verteilt. Die Dicke der "Fahrdrahtlage" entspricht der Dicke D der oberen Metallisierungslagen 5 und 6 mit ihren Versorgungsleiterbahnen 20.

Ein derartiger Lagenquerschnitt, wie er in Figur 2 gezeigt wird, basiert auf der Grundlage von rechtwinklig zueinander angeordneten Leiterbahnen 28, die über Durchgangskontakte 17 untereinander verbindbar sind. Ein derartiger Lagenquerschnitt kann deshalb mit Hilfe automatischer Verdrahtungsprogramme, wie einem PR-Programm, ohne manuellen Eingriff geplant und entworfen werden, so dass beliebige Erweiterungen der Funktionalität der integrierten Schaltung möglich werden.

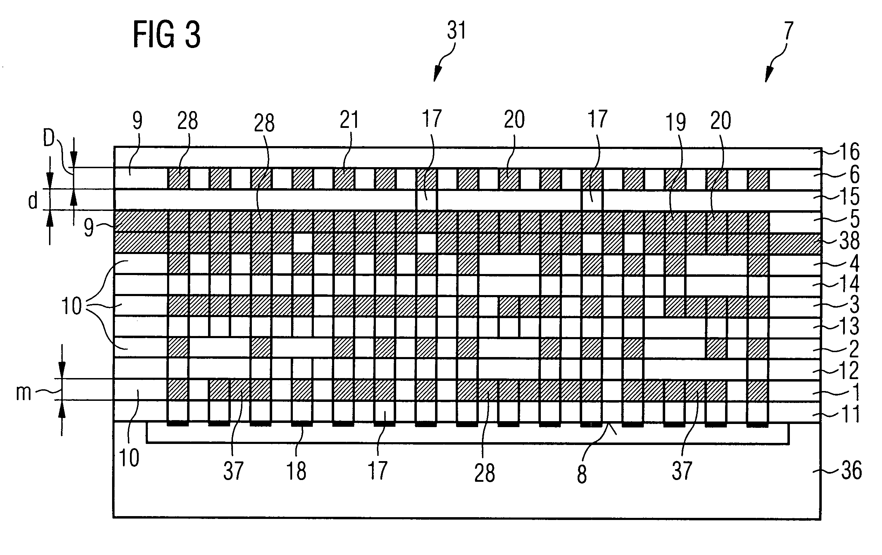

Figur 3 zeigt einen schematischen Querschnitt eines Lagenplans des Halbleiterchips 7 der Figur 2 im Winkel von 90° zu dem Lagenquerschnitt der Figur 2. In diesem schematischen Querschnitt der Figur 3, der orthogonal zu dem Querschnitt der Figur 2 dargestellt ist, wird nun eine einzelne Versorgungsleiterbahn der Metallisierungslage 5 im Querschnitt gezeigt, während die oberste Metallisierungslage sämtliche Querschnitte der Spannungsversorgungsstruktur 9 der obersten Metallisierungslage 6 zeigt. Mit diesen beiden Querschnitten der Figuren 2 und 3 wird gezeigt, dass die Spannungsversorgungsstruktur 9 der oberen beiden Metallisierungslagen 5 und 6 jeweils ein Gitter aufweist, das aus parallel zueinander angeordneten Versorgungsleiterbahnen 20 besteht. Diese Gitter sind zueinander rechtwinklig oder orthogonal angeordnet und über Durchgangskontakte 17 mit der darunter liegenden Fahrdrahtlage 38 und den nachgeordneten Modulbereichen verbunden.

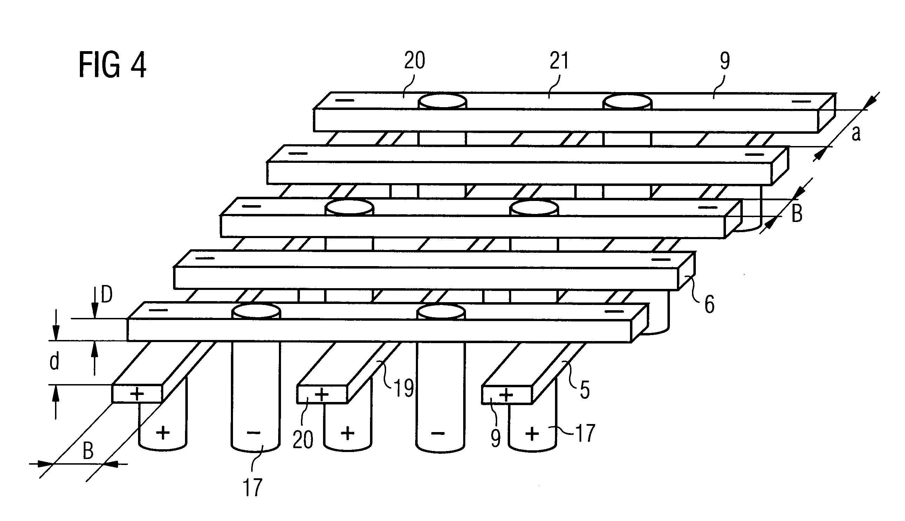

Eine detaillierte Darstellung der oberen beiden Metallisierungslagen 5 und 6 mit ihren Durchgangskontakten 17 durch die dazwischen liegende Isolationslage 15 wird in den nachfolgenden Figuren 4 bis 7 gezeigt. Komponenten mit gleichen Funktionen wie in den vorhergehenden Figuren werden in den Figuren 4 bis 7 mit gleichen Bezugszeichen gekennzeichnet und nicht extra erörtert.

Figur 4 zeigt eine schematische perspektivische Ansicht eines Ausschnitts oberer Metallisierungslagen 5 und 6 mit Durchgangskontakten 17 einer dritten Ausführungsform der Erfindung. Die oberste Metallisierungslage 6 weist parallel zueinander angeordnete Versorgungsleiterbahnen 20 auf, die auf gleichem negativem elektrischen Potential liegen. Die Dicke D jeder Versorgungsleiterbahn 20 liegt zwischen 2 und 15 µm und die Breite B richtet sich nach dem maximal zu führenden Strom durch die Versorgungsleiterbahnen 20. Von den Versorgungsleiterbahnen 20 der oberen Metallisierungslage 6 gehen Durchgangskontakte 17 aus, die mit der hier nicht gezeigten Fahrdrahtlage, wie sie die Figuren 2 und 3 zeigen, verbunden sind. Die untere zweite Metallisierungslage 5 weist Versorgungsleiterbahnen auf, die auf positivem Potential liegen und ein Gitter 21 bilden, das orthogonal zu dem Gitter der obersten Spannungsversorgungsstruktur 9 ausgerichtet ist. Von diesen Versorgungsleiterbahnen führen Durchgangskontakte 17 durch die darunter liegende Isolationslage. Die hier gezeigten Positionen der Durchgangskontakte 17 können mit Hilfe von PR-Programmen automatisch festgelegt und optimiert werden und müssen nicht den Positionen entsprechen, die in der Figur 4 dargestellt sind.

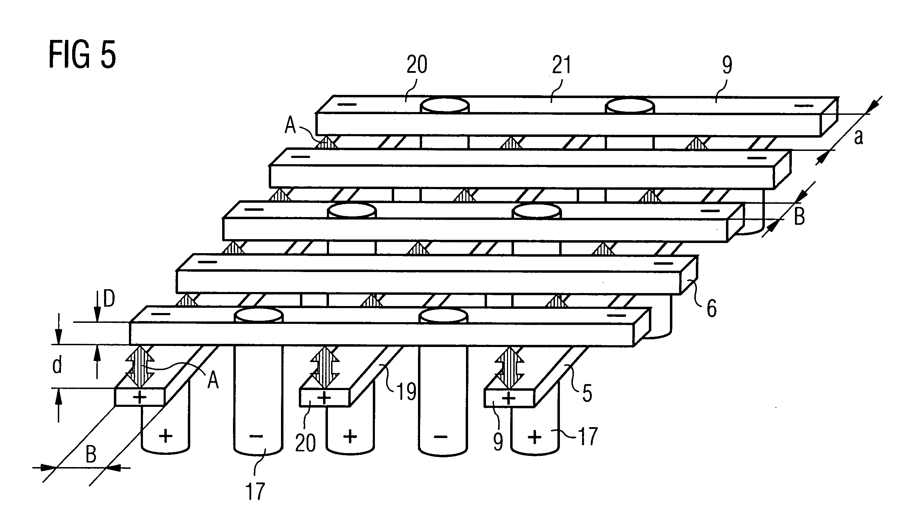

Figur 5 zeigt eine schematische perspektivische Ansicht eines Ausschnitts oberer Metallisierungslagen 5 und 6 mit Durchgangskontakten 17 der Ausführungsform der Figur 4. In Figur 5 zeigen Pfeile A, die an den Stellen angeordnet sind, an denen eine kapazitive Koppelwirkung auftritt, dass aufgrund der Potentialdifferenz zwischen der oberen Spannungsversorgungsstruktur 9 in der Metallisierungslage 6 und der unteren Spannungsversorgungsstruktur 9 in der Metallisierungslage 5 lediglich die Kreuzungsflächen jeweils zu einer kapazitiven Kopplung beitragen. Keinerlei Beitrag zu einer kapazitiven Kopplung liefert der Abstand a zwischen den parallel verlaufenden Leiterbahnen, so dass hier lediglich die Dicke d der zwischen den quer zueinander angeordneten Leiterbahngittern 21 angeordneten Isolationslage die kapazitive Kopplung beeinflusst. Dabei muss darauf geachtet werden, dass die Dicke d eine ausreichende Spannungsfestigkeit zwischen der Potentialdifferenz des negativen Potentials der obersten Metallisierungslage 6 und dem positiven Potential der darunter liegenden Metallisierungslage 5 gewährleistet.

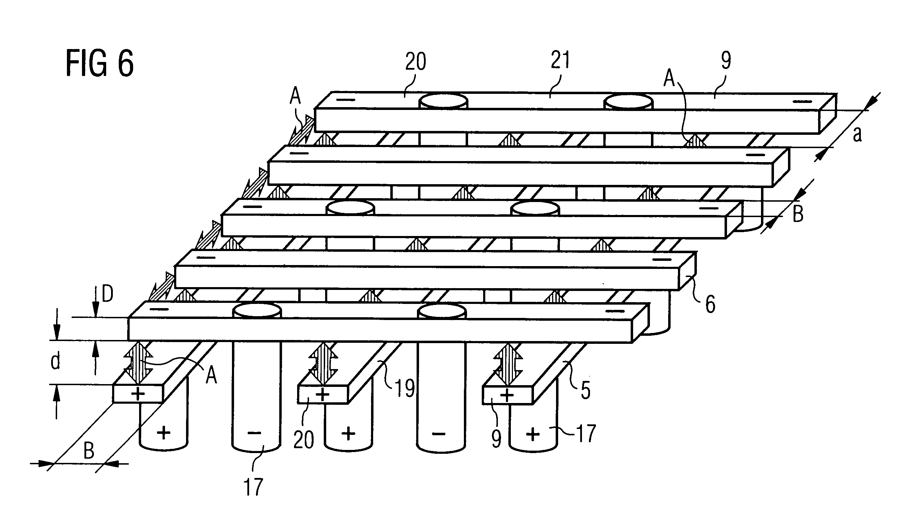

Figur 6 zeigt eine schematische perspektivische Ansicht eines Ausschnitts oberer Metallisierungslagen 5 und 6 mit Durchgangskontakten 17 einer vierten Ausführungsform der Erfindung. Bei dieser Ausführungsform der Erfindung sind wie bei der dritten Ausführrungsform der Erfindung der Figuren 4 und 5 Durchgangskontakte 17 vorgesehen, die sowohl mit der unteren Metallisierungslage 5 als auch mit der oberen Metallisierungslage 6 in Verbindung stehen. Jedoch sind die Potentiale der Versorgungsleiterbahnen 20 der oberen Metallisierungslage 6 abwechselnd mit einem niedrigen Potential oder einem hohen Potential versehen, so dass ihre im Abstand a gegenüber liegenden Längsseiten zur kapazitiven Kopplung beitragen. Die darunter liegenden und im rechten Winkel zu den darüber liegenden Versorgungsleiterbahnen 20 angeordneten Leiterbahnen 20 haben gleiches positives Potential und ihre Abstände sind auch wesentlich größer als bei der obersten Metallisierungslage, da zwischen den jeweiligen Versorgungsleiterbahnen die Durchgangskontakte 17 der darüber liegenden Metallisierungslage 5 angeordnet sind.

In der unteren Metallisierungslage 5 bildet sich einerseits aufgrund des gleichen Potentials der Versorgungsleiterbahnen 20 und andererseits aufgrund des hohen Abstandes zwischen des Versorgungsleiterbahnen 20 der unteren Metallisierungslage kein Ladungspuffer aus, so dass lediglich ein Beitrag durch die gegenüber liegenden Kreuzungsflächen auf unterschiedlichem Potential ein weiterer Beitrag zu der Koppelkapazität gebildet wird. Jedoch kann bereits durch die wesentlich höhere Koppelkapazität, die sich aufgrund der gegenüber liegenden Längsseiten der oberen Versorgungsleiterbahnen erzielen lässt, eine größere Wirkung als im dritten Ausführungsbeispiel der Erfindung erzielt werden.

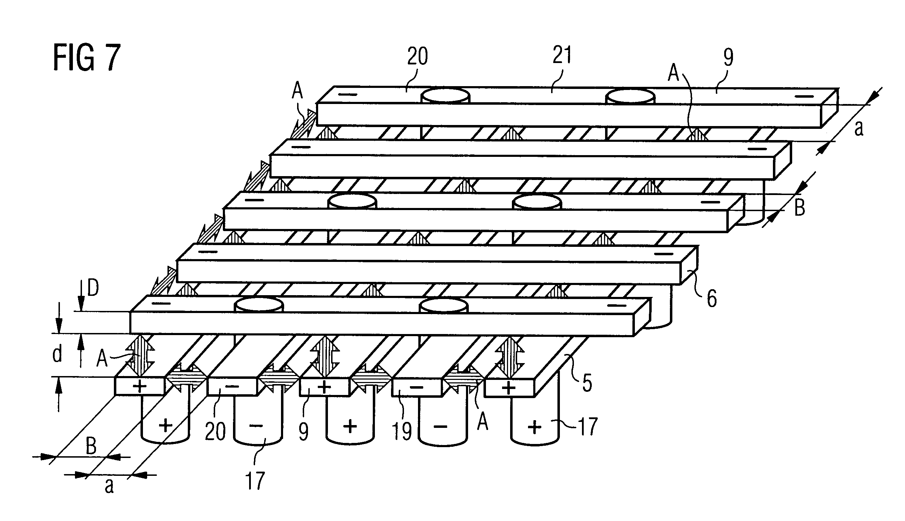

Figur 7 zeigt eine schematische perspektivische Ansicht eines Ausschnitts oberer Metallisierungslagen 5 und 6 mit Durchgangskontakten 17 einer fünften Ausführungsform der Erfindung. Mit dieser Ausführrungsform der Figur 7 wird die größte kapazitive Kopplung zwischen den Versorgungsleiterbahnen 20 erreicht, weil sowohl in der obersten Metallisierungslage 6 als in der darunter angeordneten Metallisierungslage 5 jeweils der Abstand a zwischen den Versorgungsleiterbahnen 20 derart optimiert ist, dass alle Längsseiten der Versorgungsleiterbahnen 20 zur Bildung einer hohen Koppelkapazität beitragen. Demgegenüber ist die Anzahl der Kreuzungsflächen geringer als in dem dritten Ausführungsbeispiel, jedoch höher als in dem vierten Ausführungsbeispiel, was anhand der Pfeile A sichtbar wird.

Diese höchste kapazitive Kopplung, die in vorteilhafter Weise eine schnelle Bereitstellung von Schaltströmen ermöglicht, ohne dass beispielsweise Hochfrequenz-Schaltströme die Umgebung des elektronischen Bauteils stören, wird dadurch erreicht, dass auf Durchgangskontakte 17 zu der obersten Metallisierungslage 6 verzichtet wird. Anstelle4 dessen werden von der unteren Metallisierungslage 5 aus abwechselnd beide Potentiale über Durchgangskontakte den darunter angeordneten Modulbereichen angeboten. Zusätzlich werden die Versorgungsleiterbahnen 20 der obersten Metallisierungslage wechselseitig auf unterschiedliches Potential gelegt, so dass die obere Metallisierungslage im Wesentlichen durch ihre einander gegenüber liegenden Längsseiten der Versorgungsleiterbahnen 20 die Gesamtkoppelkapazität erhöht. Sowohl die Versorgungsleiterbahnen 20 der oberen Metallisierungslage 6 als auch die Versorgungsleiterbahnen 20 der darunter liegenden Metallisierungslage 5 weisen einen gleichen optimierten Abstand a auf, der die Spannungsfestigkeit gewährleistet und gleichzeitig für eine hohe laterale Koppelkapazität sorgt.

Der durch da Gitter leitbare Strom der fünften Ausführungsform der Erfindung wird durch die Summe der Versorgungsleitungsquerschnitte der einander gegenüberliegenden Gitter 19 und 21 bestimmt. Bei einem zur Vermeidung von Elektromigration angenommenen maximalen Strom für Aluminiumleiterbahnen von 1 mA pro Mikrometer Leiterbahnbreite können durch ein flächendeckendes Gitter von 25 mm$^2$ Gitterfläche unter Berücksichtigung von vorgegebenen Design-Regeln etwa 1,5 bis 2 A Versorgungsstrom dem Halbleiterchip zugeführt werden, was ungefähr um den Faktor 5 bis 10 über einer realistischen Stromanforderung von heutigen integrierten Schaltungen dieser Größe liegt.

Die resultierende Koppelkapazität der fünften Ausführungsform der Erfindung, wie sie Figur 7 zeigt, kann wie folgt abgeschätzt werden:

$$C_v = X \cdot Y \cdot 14 \text{ pF},$$

wobei X und Y die Länge bzw. Breite der Gitterstruktur in mm beschreiben und $C_v$ die effektive vertikale Kapazität zwischen den Kreuzungsflächen ist und hinzu kommt

$$C_1 = X \cdot Y \cdot 112 \text{ pF}$$

wobei X und Y die Länge bzw. Breite der Gitterstruktur in mm beschreiben und $C_1$ die effektive laterale Kapazität zwischen Seitenflächen der Versorgungsleiterbahnen ist.

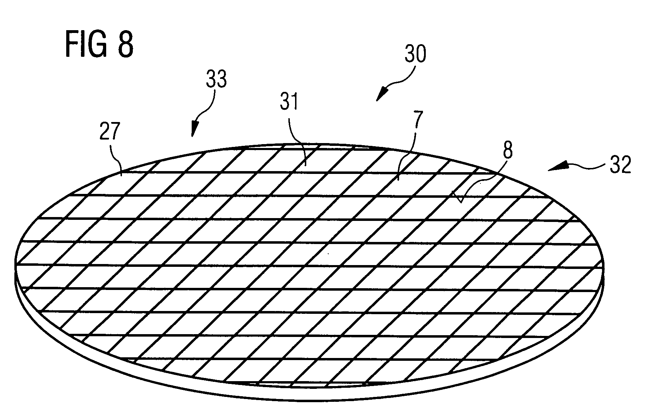

Figur 8 zeigt einen Halbleiterwafer 30 mit mehreren Halbleiterchippositionen 31 für elektronische Bauteile der Erfindung. Derartige Halbleiterwafer 30 werden zunehmend Handelsobjekte und werden geprüft und ungeprüft an entsprechende Kunden ausgeliefert. Bei geprüften Halbleiterwafern 30 werden die nicht-funktionsfähigen Halbleiterchips 7 vorsorglich markiert, damit sie nach dem Trennen des Halbleiterwafers 30 in mehrere Halbleiterchips 7 nicht weiter verarbeitet werden. Demgegenüber werden die funktionsfähigen Halbleiterchips 7 einer Weiterverarbeitung zugeführt. Der Halbleiterwafer 30 selbst weist die Halbleiterchippositionen 31 in Zeilen 32 und Spalten 33 auf, die rechtwinklig zueinander verlaufen, so dass durch einfache Sägetechnik die Halbleiterchips 7 vereinzelt werden können. Ein derartiger Halbleiterwafer 30 weist bereits in jeder Halbleiterchipposition 31 sämtliche Verdrahtungsebenen der Erfindung auf, so dass nach dem Zerteilen in einzelne Halbleiterchips 7 lediglich das Aufbringen auf einen Schaltungsträger, das Bonden von Bondverbindungen und ein Verpacken in einem entsprechenden Gehäuse durchgeführt werden muss, um ein erfindungsgemäßes elektronisches Bauteil herzustellen.

Bezugszeichenliste

| | |
|---|---|
| 1-6 | Metallisierungslagen |
| 7 | Halbleiterchip |
| 8 | aktive Oberseite |
| 9 | Spannungsversorgungsstruktur |
| 10 | Signalleitungsstruktur |
| 11-15 | Isolationslagen |
| 16 | Passivierungsschicht |
| 17 | Durchgangskontakte |
| 18 | Kontaktflächen |
| 19 | Gitter |
| 20 | Versorgungsleiterbahnen |
| 21 | Gitter, das gegenüber dem Gitter 19 verdreht ist |
| 22-26 | Funktionsmodulbereiche |
| 27 | integrierte Schaltung |
| 28 | Leiterbahnen |
| 29 | Kontaktanschlussflächen |
| 30 | Halbleiterwafer |
| 31 | Halbleiterchipposition |
| 32 | Zeilen |
| 33 | Spalten |
| 34 | gestrichelte Linie |
| 35 | Randbereich |
| 36 | Halbleitersubstrat |
| 37 | Signalleiterbahnen |
| 38 | Fahrdrahtlage |

| | |
|---|---|
| A | Pfeile |
| a | Abstand der parallel angeordneten Versorgungsleiterbahnen |
| B | Breite der Versorgungsleiterbahnen |
| d | Dicke der Isolationslagen |
| D | Dicke der Versorgungsleiterbahnen |
| m | Dicke der Signalleiterbahnen |

**Patentansprüche**

1.   Elektronisches Bauteil mit einem Halbleiterchip (7), der auf seiner aktiven Oberseite (8) im Wechsel übereinander angeordnete Metallisierungslagen (1-6) und Isolationslagen (11-15) aufweist, wobei die Metallisierungslagen (1-6) Spannungsversorgungsstrukturen (9) und/oder Signalleitungsstrukturen (10) aufweisen, und wobei in den Isolationslagen (11-15) angeordnete Durchgangskontakte (17) die Spannungsversorgungsstrukturen (9) und die Signalleitungsstrukturen (10) mit Kontaktflächen (18) der aktiven Oberseite (8) verbinden, **dadurch gekennzeichnet, dass** die obersten Metallisierungslagen (5, 6) flächendeckende Spannungsversorgungsstrukturen (9) mit dazwischen angeordneten Isolationslagen (15) mit Durchgangskontakten (17) zu den Kontaktflächen (18) aufweisen und mindestens zwei voneinander isolierte Spannungsversorgungsstrukturen (9) für ein niedriges (-) und für ein hohes (+) Versorgungspotential (-, +) aufweisen, und wobei die darunter angeordneten Metallisierungslagen (1-4) Signalleitungsstrukturen (10) aufweisen, und wobei die Spannungsversorgungsstrukturen (9) der oberen Metallisierungslagen (5, 6) jeweils Gitter (19) von parallel zueinander angeordneten Versorgungsleiterbahnen (20) aufweisen und aufeinanderfolgende Gitter (19, 21) gegeneinander verdreht sind.

2.   Elektronisches Bauteil nach Anspruch 1, **dadurch gekennzeichnet, dass** der Halbleiterchip (7) eine in Funktionsmodulbereiche (22-26) gegliederte integrierte Schaltung (27) aufweist, wobei jeder Modulbereich (22-26) über seine Kontaktflächen (18) und über Durchgangskontakte (17) mit den Spannungsversorgungsstrukturen (9) der oberen Metallisierungslagen (5, 6) verbunden ist.

3.   Elektronisches Bauteil nach Anspruch 1 oder Anspruch 2, **dadurch gekennzeichnet, dass** der Halbleiterchip (7) einen Siliciumchip aus monokristallinem Material aufweist und in dem Bereich seiner aktiven Oberseite (8) eine integrierte Schaltung (27) aufweist, deren Kontaktflächen (18) mit den darüber angeordneten Leiterbahnen (28) über Durchgangskontakte (17) der Isolationslagen (11-15) elektrisch verbunden sind, wobei die elektrischen Verbindungen automatisch mittels Place-Route Programmen verdrahtbar sind.

4. Elektronisches Bauteil nach einem der vorhergehenden Ansprüche
   **dadurch gekennzeichnet, dass**
   die parallel zueinander innerhalb einer Metallisierungslage (5, 6) angeordneten Versorgungsleiterbahnen (9) alternierend unterschiedliche elektrische Versorgungspotentiale (+, -) aufweisen.

5. Elektronisches Bauteil nach einem der vorhergehenden Ansprüche,
   **dadurch gekennzeichnet, dass**
   Abstände (a) der innerhalb einer Metallisierungslage (5, 6) parallel zueinander angeordneten Versorgungsleiterbahnen (9) mit alternierenden Versorgungspotentialen (+, - ) derart dimensioniert sind, dass sie eine höchstmögliche elektrische Kapazität mit ausreichender Spannungsfestigkeit aufweisen.

6. Elektronisches Bauteil nach einem der vorhergehenden Ansprüche,
   **dadurch gekennzeichnet, dass**
   die parallel zueinander angeordneten Versorgungsleiterbahnen (9) der innerhalb der obersten Metallisierungslagen (5, 6) gleiche elektrische Versorgungspotentiale (+, - ) und zwischen den Metallisierungslagen (5, 6) unterschiedliche Versorgungspotentiale (+, -) aufweisen.

7. Elektronisches Bauteil nach einem der vorhergehenden Ansprüche,
   **dadurch gekennzeichnet, dass**
   die Dicke (d) der Isolationslagen zwischen den obersten Metallisierungslagen (5, 6) derart dimensioniert ist,
   dass sie an übereinander angeordneten Flächen der Metallisierungslagen (5, 6) eine höchstmögliche elektrische Kapazität mit ausreichender Spannungsfestigkeit aufweisen.

8. Elektronisches Bauteil nach einem der vorhergehenden Ansprüche,
   **dadurch gekennzeichnet, dass**
   die Metallisierungslagen (1-6) polykristallines Silizium, Kupfer, Aluminium, Nickel oder Legierungen des Kupfers, des Aluminiums oder des Nickels aufweisen.

9. Elektronisches Bauteil nach einem der vorhergehenden Ansprüche,
   **dadurch gekennzeichnet, dass**
   die Isolationslagen (11-15) Siliciumdioxid, Siliciumnitrid oder polymere Kunststoffe aufweisen.

10. Elektronisches Bauteil nach einem der vorhergehenden Ansprüche,
    **dadurch gekennzeichnet, dass**
    Dicke (D) und Breite (B) der Versorgungsleiterbahnen (20) der Spannungsversorgungsstrukturen (9) größer ist als Dicke und Breite der Leiterbahnen (28) der Signalleitungsstrukturen (10).

11. Halbleiterwafer mit mehreren Halbleiterchippositionen (31), die in Zeilen (32) und Spalten (33) auf einer aktiven Oberseite (8) des Halbleiterwafers (30) angeordnet sind, wobei der Halbleiterwafer (30) im Wechsel übereinander angeordnete strukturierte Metallisierungslagen (1-6) und Isolationslagen (11-15) mit Durchgangskontakten (17) in jeder Halbleiterchipposition (31) aufweist, und wobei die in den Isolationslagen (11-15) angeordneten Durchgangskontakte (17) Spannungsversorgungsstrukturen (9) und/oder Signalleitungsstrukturen (10) der Metallisierungslagen (1-6) mit Kontaktflächen (18) auf der aktiven Oberseite (8) verbinden,
    **dadurch gekennzeichnet, dass**
    die oberen Metallisierungslagen (5, 6) flächendeckende Spannungsversorgungsstrukturen (9) mit dazwischen angeordneten Isolationslagen (15) in jeder Halbleiterchipposition (31) aufweisen mit mindestens zwei voneinander isolierten Spannungsversorgungsstrukturen (9) für ein niedriges (-) und für ein hohes (+) Versorgungspotential (+, -), wobei Durchgangskontakte 17 diese Versorgungspotentiale über eine Fahrdrahtlage mit darunter angeordnete Modulbereichen (22-26) elektrisch verbinden, wobei die darunter angeordneten Metallisierungslagen (1-4) Signalleitungsstrukturen (10) aufweisen, und wobei die darüber angeordneten Spannungsversorgungsstrukturen (9) jeweils ein Gitter (19) von parallel zueinander angeordneten Versorgungsleiterbahnen (20) aufweisen und aufeinander folgende Gitter (19, 21) gegeneinander verdreht sind.

12. Elektronisches Bauteil nach Anspruch 11,
    **dadurch gekennzeichnet, dass**
    jede Halbleiterchipposition (31) eine in Funktionsmodulbereiche (22-26) gegliederte integrierte Schaltung (27) aufweist, wobei jeder Modulbereich (22-26) über seine Kontaktflächen (18) und über Durchgangskontakte (17) mit den Spannungsversorgungsstrukturen (9) der oberen Metallisierungslagen (5, 6) verbunden ist.

13. Halbleiterwafer nach Anspruch 11 oder Anspruch 14,
    **dadurch gekennzeichnet, dass**
    der Halbleiterwafer (30) einen Siliciumwafer aus monokristallinem Material aufweist und in dem Bereich seiner aktiven Oberseite (8) eine integrierte Schaltung (27) aufweist, deren Kontaktflächen (18) mit den darüber angeordneten Signalleiterbahnstrukturen (10) und den Spannungsversorgungsstrukturen (9) der obersten Metallisierungslagen (5, 6) über die Durchgangskontakte (17) der Isolationslagen (11-15) elektrisch verbunden sind, wobei die elektrischen Verbindungen automatisch mittels Place-Route Programmen verdrahtbar sind.

**14.** Halbleiterwafer nach einem der Ansprüche 11 bis 13,
   **dadurch gekennzeichnet, dass**
   die parallel zueinander innerhalb einer Metallisierungslage (5, 6) angeordneten Versorgungsleiterbahnen (20) alternierend unterschiedliche elektrische Versorgungspotentiale (+, -) aufweisen.

**15.** Halbleiterwafer nach einem der Ansprüche 11 bis 14,
   **dadurch gekennzeichnet, dass**
   Abstände (a) der innerhalb einer Metallisierungslage (5, 6) parallel zueinander angeordneten Versorgungsleiterbahnen (20) mit alternierenden Versorgungspotentialen (+, -) derart dimensioniert sind, dass sie eine höchstmögliche elektrische Kapazität mit ausreichender Spannungsfestigkeit aufweisen.

**16.** Halbleiterwafer nach einem der Ansprüche 13 bis 15
   **dadurch gekennzeichnet, dass**
   die parallel zueinander angeordneten Versorgungsleiterbahnen (20) der innerhalb der obersten Metallisierungslagen (5, 6) gleiche elektrische Versorgungspotentiale und zwischen den Metallisierungslagen (5, 6) unterschiedliche Versorgungspotentiale (+, -) aufweisen.

**17.** Halbleiterwafer nach einem der Ansprüche 11 bis 16,
   **dadurch gekennzeichnet, dass**
   die Dicke (d) der Isolationslagen (15) zwischen den obersten Metallisierungslagen (5, 6) derart dimensioniert ist, dass sie an übereinander angeordneten Flächen der Metallisierungslagen (5, 6) eine höchstmögliche elektrische Kapazität mit ausreichender Spannungsfestigkeit aufweisen.

**18.** Verfahren zur Herstellung eines Halbleiterwafers (30) mit mehreren Halbleiterchippositionen (31) und mit mindestens zwei oberen Metallisierungslagen (5, 6) als Spannungsversorgungsstrukturen (9) mit parallelen Versorgungsleiterbahnen (20) in jeder der Halbleiterchippositionen (31), wobei die parallelen Versorgungsleitungen (20) der obersten Metallisierungslage (6) quer zu den parallelen Versorgungsleitungen der darunter angeordneten Metallisierungslage (5) ausgerichtet sind, und wobei das Verfahren folgende Verfahrensschritte aufweist:

-   Bereitstellen eines Halbleiterwafers (30) mit mehreren Halbleiterchippositionen (31), die Signalleitungsstrukturen (10) aufweisende Metallisierungslagen (1-4) und dazwischen angeordneten Isolationslagen (11-14) mit Durchgangskontakten (17) aufweisen, wobei die Signalleitungsstrukturen (10) über die Durchgangskontakte (17) mit Kontaktflächen (18) auf der aktiven Oberseite (8) des Halbleiterwafers (30) verbunden sind,
-   Aufbringen einer geschlossenen Metallisierungslage auf eine oberste Isolationslage (14) der Signalleitungsstrukturen (10),
-   Strukturieren der geschlossenen Metallisierungslage zu einem Gitter (19) aus parallelen Versorgungsleiterbahnen (20) als erste Spannungsversorgungsstruktur (5), wobei die Lage der Versorgungsleiterbahnen (20) mittels Place-Route-Programmen automatisch entworfen werden,
-   Aufbringen einer Isolationslage (15) auf die Spannungsversorgungsstruktur (5) mit Durchgangskontakten (17) zu Kontaktflächen (18) auf der aktiven Oberseite (8), wobei die Positionierung der Durchgangskontakte (17) mit einer Photolithographiemaske erfolgt, die mittels Place-Route-Programmen automatisch entworfen wird,
-   Aufbringen und Strukturieren einer weiteren Metallisierungslage (6) mit einem Gitter (19) aus parallelen Versorgungsleiterbahnen (20), die quer zu der Richtung der ersten Spannungsversorgungsstruktur (9) angeordnet sind und deren Lage mittels Place-Route-Programmen automatisch entworfen werden,
-   Aufbringen einer Passivierungsschicht (16) unter Freilassen von Kontaktanschlussflächen, die mit Durchgangskontakten (17) elektrische in Verbindung stehen.

**19.** Verfahren zur Herstellung eines elektronischen Bauteils unter Auftrennen des gemäß Anspruch 18 hergestellten Halbleiterwafers (31) in Halbleiterchips (7), wobei das Verfahren weiterhin folgende Verfahrensschritte aufweist:

-   Aufbringen der Halbleiterchips(7) auf einen Schaltungsträger mit mehreren Bauteilpositionen,
-   Herstellen von Bondverbindungen zwischen dem Schaltungsträger und den Kontaktanschlußflächen (29) der Halbleiterchips (7) in jeder Bauteilposition,
-   Verpacken der Halbleiterchips (7) mit Bondverbindungen in einem Kunststoffgehäuse mit Außenkontakten in jeder Bauteilposition,
-   Auftrennen des Schaltungsträgers in mehrere elektronische Bauteile.

FIG 1

FIG 2

EP 1 398 834 A2

FIG 3

# FIG 4

EP 1 398 834 A2

FIG 5

FIG 6

EP 1 398 834 A2

FIG 7

EP 1 398 834 A2

FIG 8